# EUROPEAN PATENT APPLICATION

(11) **EP 2 357 688 A1**
(43) Date of publication of application: **17.08.2011**
(21) Application number: 09831709.2
(22) Date of filing: 10.12.2009
(51) Int. Cl.: H01M 2/10, H01M 2/12, H01M 2/20

(54) **BATTERY MODULE AND BATTERY MODULE ASSEMBLY USING SAME**

(30) Priority: 10.12.2008 JP 2008314030
(71) Applicant: Panasonic Corporation, Kadoma-shi Osaka 571-8501 (JP)
(72) Inventor: YASUI, Shunsuke, 2-1-61 Shiromi, Chuo-ku, Osaka-shi, Osaka 540-6207 (JP); NAKASHIMA, Takuya, 2-1-61 Shiromi, Chuo-ku, Osaka-shi, Osaka 540-6207 (JP); HIRAKAWA, Yasushi, 2-1-61 Shiromi, Chuo-ku, Osaka-shi, Osaka 540-6207 (JP); ASAKURA, Jun, 2-1-61 Shiromi, Chuo-ku, Osaka-shi, Osaka 540-6207 (JP)
(74) Representative: Grünecker, Kinkeldey, Stockmair & Schwanhäusser Anwaltssozietät
(86) International application number: PCT/JP2009/006740
(87) International publication number: WO 2010/067602

(57) **Abstract**

The battery module includes a plurality of battery units, a housing, a wiring board, and a lid. The battery unit is composed of one or more battery cells each having a vent mechanism. At least one surface of the housing is an open end. The housing has a plurality of storage parts partitioned by one or more partition walls. Each battery unit is stored in each storage part. The wiring board covers the open end of the housing, is disposed at the vent mechanism side of the cell, and has connection terminals connected to the battery units. The lid covers the open end of the housing and the wiring board, and has an open part. Through holes are provided on the wiring board in positions facing the battery units and in a different region from that of the connection terminals.

## Description

### TECHNICAL FIELD

The present invention relates to a battery module having a structure in which failure such as heat generation occurring in a battery cell does not affect other cells, and a battery module assembly using the battery module.

### BACKGROUND ART

Recently, from the viewpoint of resource savings and energy savings, secondary batteries such as nickel hydrogen secondary battery, nickel cadmium secondary battery and lithium ion secondary battery, which can be used repeatedly, are increasingly demanded. Among them, the lithium ion secondary battery has light weight, high electromotive force, and large energy density. Therefore, demand for lithium ion secondary batteries is increased as driving power sources for various portable electronic apparatuses and mobile telecommunication apparatuses such as portable telephones, digital cameras, video cameras, notebook-sized personal computers and the like.

On the other hand, in order to reduce the amount of fossil fuel to be used and amount of CO₂ emissions, a battery pack as a power source for driving a motor of an automobile or the like is increasingly expected. The battery pack is configured by using a plurality of battery units each including one or more battery cells in order to obtain a desired voltage or capacity.

In a battery module, as the number of battery units to be mounted is increased, space for routing power lines and control wiring is required. This makes it difficult to reduce the size of the battery module.

Thus, a configuration of a battery unit is disclosed including a plurality of battery cells, in which connecting lines between the cells and wiring for detecting a voltage, a temperature, and the like, are connected by pattern wirings formed on a printed circuit board (see, for example, Patent Literature 1). Similarly, a power source device is disclosed in which a plurality of power source modules are stored in a holder case and connected to each other via an end plate (for example, Patent Literature 2). The end plate is provided with a power source lead and a sensor lead for connecting power source modules. This configuration can reduce connection failure and reduce the size of the power source device.

Furthermore, as the capacity of battery cells to be stored in a battery module is increased, each battery cell itself may generate heat to high temperatures depending on the mode of use. Therefore, in addition to the safety of the cell itself, the safety of the battery module combining a plurality of battery units each of which assembles the cells becomes more important. That is to say, in a cell, an internal pressure rises due to gas generated by overcharge, overdischarge, or internal short-circuit or external short-circuit, and occasionally, an external case of the cell may rupture. Therefore, in general, the cell is provided with a vent mechanism, a safety valve, or the like, for extracting gas, so that internal gas is released when unexpected circumstances occur. At this time, the exhausted gas may ignite, so that the gas may produce smoke, or, although rarely, catch fire.

Then, a power source device is disclosed in which a plurality of cells are stored in a battery chamber in a case, and an open part is provided in a separation wall facing a safety valve of each cell (see, for example, Patent Literature 3). In this power source device, gas ejected from the cell at an abnormal state is exhausted from an exhaust port via the exhaust chamber.

However, in the battery modules described in Patent Literatures 1 and 2, when one cell abnormally generates heat and a safety valve works, an amount of heat of the cell that generates heat or the influence on the surrounding batteries by ignition to the ejected gas cannot be suppressed. Therefore, the battery units may be deteriorated one after another. In particular, a battery module in which battery units are mounted has a problem of how to suppress and minimize the expansion of the influence of the battery unit in an abnormal state to the surrounding battery units.

Furthermore, in the power source device disclosed in Patent Literature 3, an open part is provided in a separation wall of a case so as to face the safety valve of the battery, thereby exhausting the ejected gas to the outside so that the gas do not fill the battery chamber. However, similar to Patent Literatures 1 and 2, when one cell abnormally generates heat before the safety valve works, the surrounding cells are heated one after another by emission, radiation, or the like, of the heat of the cell that generates heat. Since the amount of heat generation is increased synergistically as the number of the cells stored in the battery chamber is increased, it is not possible to minimize the influence on the surrounding cells. Although a circuit board incorporated in resin is disclosed, connection to a cell, a control method and the like are neither disclosed nor suggested. Furthermore, since the circuit board is incorporated in resin, reduction in size of the battery module is limited.

### [Citation List]

### [Patent Literature]

Patent Literature 1: Japanese Patent Application Unexamined Publication No. 2000-208118
Patent Literature 2: Japanese Patent Application Unexamined Publication No. 2000-223166
Patent Literature 3: Japanese Patent Application Unexamined Publication No. 2007-27011

### SUMMARY OF THE INVENTION

The present invention provides a battery module capable of reducing space for wiring and of minimizing the influence of abnormal heat generation of a battery cell with failure on the surrounding battery cells, and a battery module assembly using the battery module.

The battery module of the present invention includes a plurality of battery units, a housing, a wiring board, and a lid. Each of the battery units is composed of one or more battery cells each having a vent mechanism. At least one surface of the housing is an open end. The housing has a plurality of storage parts partitioned by one or more partition walls. Each battery unit is stored in each storage part. The wiring board covers the open end of the housing, is disposed at the vent mechanism side of the battery cells, and has a connection terminal connected to the battery units. The lid covers the open end of the housing and the wiring board, and has an open part. Through holes are provided in positions facing the battery units and in a different region from that of the connection terminals in the wiring board.

With this configuration, it is possible to store the battery unit in the storage part of the housing with at least the wiring board and the partition wall in a sealed state. Therefore, even if a battery unit is in an abnormal state, gas, which is ejected by opening of a vent mechanism of a cell, is not supplied with oxygen from the outside, and is exhausted to the outside of the battery module in a state of gas via the through hole of the wiring board. Furthermore, since each battery unit is stored in a partitioned storage part in the housing, heat transfer to the surrounding battery units is suppressed and an influence of the heat can be minimized. Moreover, space necessary for routing power supply wiring, control wiring, or the like, can be considerably reduced by the wiring board. As a result, a battery module having a small size, high safety, and excellent reliability can be achieved.

The battery module assembly of the present invention has a configuration in which a plurality of the battery modules are combined at least one of in series and in parallel. With this configuration, depending on the intended use, a battery module assembly having any voltage or capacity can be achieved.

According to the present invention, a battery module capable of reducing space for wiring and of minimizing the influence of abnormal heat generation of a battery unit with failure on the surrounding battery units, and a battery module assembly using the battery module can be achieved.

### BRIEF DESCRIPTION OF THE DRAWINGS

Fig. 1 is a cross-sectional view of a battery cell stored in a battery unit in accordance with a first exemplary embodiment of the present invention.
Fig. 2A is an outline perspective view of a battery module in accordance with the first exemplary embodiment of the present invention.
Fig. 2B is a sectional view taken along line 2B-2B of Fig. 2A.
Fig. 2C is an enlarged sectional view of part 2C in Fig. 2B.
Fig. 3 is an exploded perspective view of the battery module in accordance with the first exemplary embodiment of the present invention.
Fig. 4 is a perspective view illustrating a structure of a lid of the battery module in accordance with the first exemplary embodiment of the present invention.
Fig. 5A is a perspective view illustrating a wiring board of the battery module in accordance with the first exemplary embodiment of the present invention.
Fig. 5B is a sectional view taken along line 5B-5B of Fig. 5A.
Fig. 5C is a plan view of the wiring board shown in Fig. 5A.
Fig. 6A is a sectional view illustrating a state in which gas ejected when abnormal heat generation occurs in one battery unit is exhausted in the battery module in the first exemplary embodiment of the present invention.
Fig. 6B is an enlarged sectional view of part 6B of Fig. 6A.
Fig. 7A is a sectional view illustrating another example of a wiring board of a battery module in accordance with the first exemplary embodiment of the present invention.
Fig. 7B is an enlarged sectional view of part 7B of Fig. 7A.
Fig. 8 is an exploded perspective view illustrating another example of a battery module in accordance with the first exemplary embodiment of the present invention.
Fig. 9 is a perspective view illustrating another example of a lid in accordance with the first exemplary embodiment of the present invention.
Fig. 10 is an exploded perspective view illustrating another example of a housing in accordance with the first exemplary embodiment of the present invention.
Fig. 11A is an outline perspective view illustrating another example of a battery module in accordance with the first exemplary embodiment of the present invention.
Fig. 11B is a sectional view taken along line 11B-11B of Fig. 11A.
Fig. 12A is a sectional view of a battery module in accordance with a second exemplary embodiment of the present invention.
Fig. 12B is an enlarged sectional view of part 12B in Fig. 12A.
Fig. 13A is a sectional view illustrating another example of a wiring board of a battery module in accordance with the second exemplary embodiment of the present invention.
Fig. 13B is an enlarged sectional view of part 13B in Fig. 13A.
Fig. 14A is a sectional view illustrating still another example of a wiring board of a battery module in accordance with the second exemplary embodiment of the present invention.
Fig. 14B is an enlarged sectional view of part 14B in Fig. 14A.
Fig. 15 is an exploded perspective view illustrating another example of a battery module in accordance with the second exemplary embodiment of the present invention.
Fig. 16A is an assembly perspective view of a battery module assembly in accordance with a third exemplary embodiment of the present invention.
Fig. 16B is an assembly perspective view of another example of a battery module assembly in accordance with the third exemplary embodiment of the present invention.
Fig. 17 is an exploded perspective view of still another example of a battery module assembly in accordance with the third exemplary embodiment of the present invention.

### DETAILED DESCRIPTION OF THE PREFERRED EMBODIMENTS

Hereinafter, exemplary embodiments of the present invention are described with reference to drawings in which the same reference numerals are given to the same components. Note here that the present invention is not limited to the contents mentioned below as long as it is based on the basic features described in this specification. Furthermore, in the below description, a non-aqueous electrolyte secondary battery such as a lithium ion battery (hereinafter, referred to as a "battery") is described as an example of a battery cell. However, the present invention is not limited to this example.

### (FIRST EXEMPLARY EMBODIMENT)

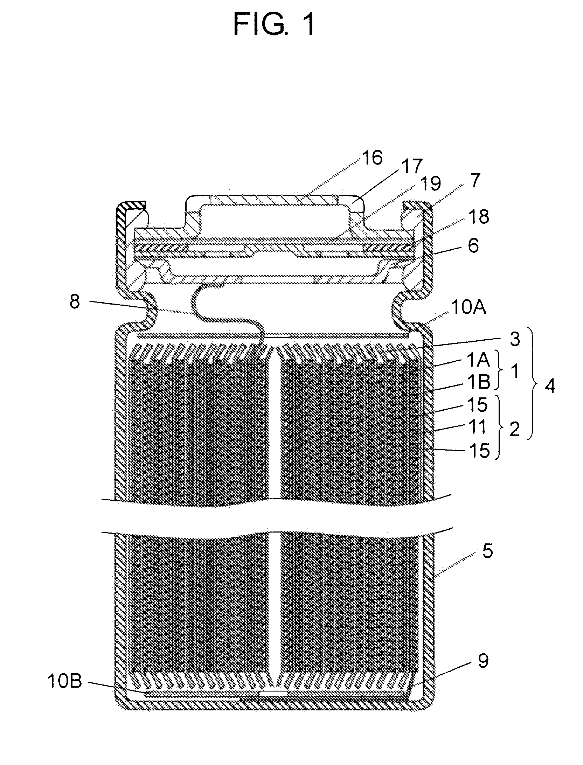

Fig. 1 is a cross-sectional view of a battery cell constituting a battery unit in accordance with a first exemplary embodiment of the present invention. Hereinafter, even when a battery unit includes only one cell, it is referred to as a battery unit, but for convenience of description, it is also referred to as a battery cell.

As shown in Fig. 1, a cylindrical battery includes electrode group 4 formed of positive electrode 1, negative electrode 2 and separator 3. To positive electrode 1, positive electrode lead 8 made of, for example, aluminum is connected. Negative electrode 2 faces positive electrode 1. To one end of negative electrode 2, negative electrode lead 9 made of, for example, copper is connected. Separator 3 is interposed between positive electrode 1 and negative electrode 2. In this state, positive electrode 1, negative electrode 2 and separator 3 are wound to form electrode group 4.

On the top and bottom of electrode group 4, insulating plates 10A and 10B are placed. In this state, electrode group 4 is inserted into battery case 5. The other end of positive electrode lead 8 is welded to sealing plate 6, and the other end of negative electrode lead 9 is welded to the bottom of battery case 5. Furthermore, a non-aqueous electrolyte (not shown) conducting lithium ion is filled in battery case 5. An open end of battery case 5 is caulked to positive electrode cap 16, current blocking member 18 such as a PTC element, and sealing plate 6 via gasket 7.

Vent mechanism 19 such as a safety valve is opened when failure occurs in electrode group 4. Positive electrode cap 16 is provided with vent hole 17 for extracting gas generated when vent mechanism 19 is opened.

Positive electrode 1 includes positive electrode current collector 1A and positive electrode layer 1B containing positive electrode active material. Positive electrode layer 1B includes a lithium-containing composite oxide such as LiCoO₂, LiNiO₂, and Li₂MnO₄ or a mixture or a composite compound thereof, as the positive electrode active material. Furthermore, positive electrode layer 1B further includes a conductive agent and a binder. Examples of the conductive agent include graphites such as natural graphites and artificial graphites; and carbon blacks such as acetylene black, Ketjen black, channel black, furnace black, lampblack, thermal black, and the like. Furthermore, examples of the binder include PVDF, polytetrafluoroethylene, polyethylene, polypropylene, aramid resin, polyamide, polyimide, and the like. As positive electrode current collector 1A, aluminum (A1), carbon (C), conductive resin, and the like, can be used.

As the non-aqueous electrolyte, an electrolyte solution obtained by dissolving a solute in an organic solvent, or a so-called a polymer electrolyte layer including the electrolyte solution and immobilized by a polymer can be used. Examples of the solute of the nonaqueous electrolyte may include LiPF₆, LiBF₄, LiClO₄, LiAlCl₄, LiSbF₆, LiSCN, LiCF₃SO₃, LiN(CF₃CO₂), LiN(CF₃SO₂)₂, and the like. Furthermore, examples of the organic solvent may include ethylene carbonate (EC), propylene carbonate, butylene carbonate, vinylene carbonate, dimethyl carbonate (DMC), diethyl carbonate, ethyl methyl carbonate (EMC), and the like.

Negative electrode 2 includes negative electrode current collector 11 and negative electrode layer 15 containing negative electrode active material. As negative current collector 11, a metal foil of, for example, stainless steel, nickel, copper, and titanium, and a thin film of carbon and conductive resin are used. As negative electrode layer 15, negative electrode active materials capable of reversibly absorbing and releasing lithium ions can be used. For example, carbon materials such as graphite, silicon (Si), tin (Sn), or the like having a theoretical capacity density of more than 833 mAh/cm³, can be used.

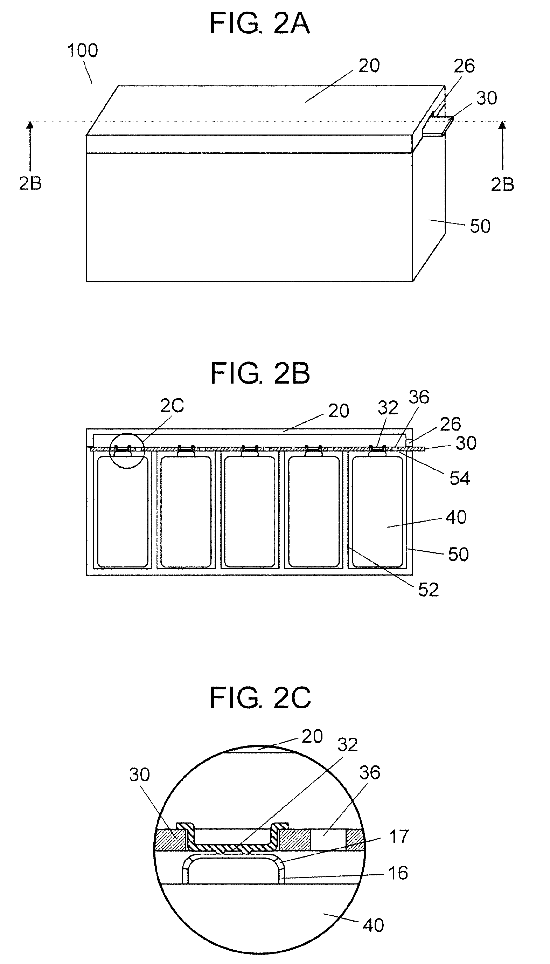

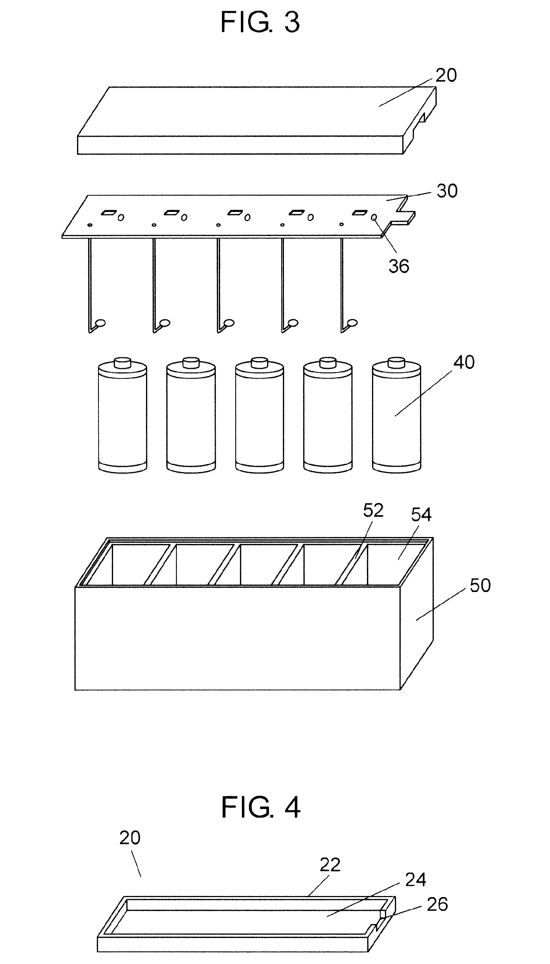

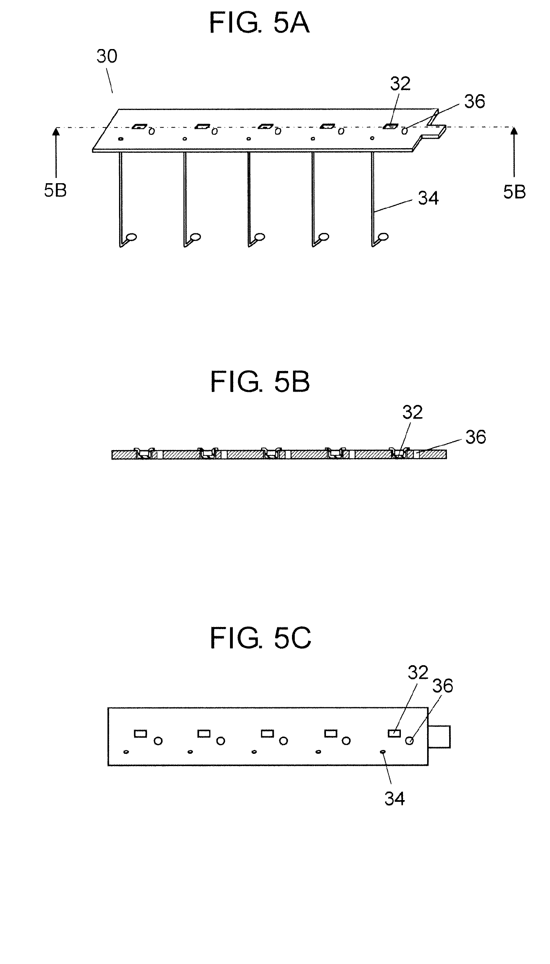

Hereinafter, a battery module in accordance with this exemplary embodiment is described in detail with reference to Fig. 2A to Fig. 5. Fig. 2A is an outline perspective view of the battery module in accordance with this exemplary embodiment. Fig. 2B is a sectional view taken along line 2B-2B of Fig. 2A. Fig. 2C is an enlarged sectional view of part 2C in Fig. 2B. Fig. 3 is an exploded perspective view of the battery module in accordance with this exemplary embodiment. Fig. 4 is a perspective view illustrating a structure of a lid of the battery module in accordance with this exemplary embodiment. Fig. 5A is a perspective view illustrating a wiring board of the battery module in accordance with this exemplary embodiment. Fig. 5B is a sectional view taken along line 5B-5B of Fig. 5A. Fig. 5C is a plan view of Fig. 5A.

As shown in Fig. 2A and Fig. 3, battery module 100 includes housing 50, lid 20 and wiring board 30. Housing 50 is made of, for example, an insulating resin material such as polycarbonate resin. Lid 20 is fitted with housing 50. Inside this fitted body, a plurality of battery units 40 electrically connected to wiring board 30 are stored. For example, each battery unit 40 including one cell is stored in a sealed space formed by storage part 54 of housing 50 and wiring board 30. Basically, each battery unit 40 communicates with the outside via through hole 36 formed in wiring board 30, which is described below in detail.

Hereinafter, with reference to the drawings, each component constituting battery module 100 is described. As shown in Fig.3, housing 50 has an open end on the side where housing 50 is fitted with lid 20. That is to say, one surface of housing 50 is an open end. Housing 50 includes a plurality of storage parts 54 for individually accommodating battery units 40 from the open end. That is to say, the inside of housing 50 is partitioned by partition walls 52. In a case that a cell as battery unit 40 has, for example, an outer diameter of 18 mm and height of 65 mm, the height of partition wall 52 is about 65 mm with the thickness of connection plate 34 of wiring board 30 mentioned below added.

Lid 20 covers the open end of housing 50 and wiring board 30. As shown in Fig. 4 showing lid 20 upside down, lid 20 includes exhaust chamber 24 formed by peripheral wall 22 and open part 26 provided in a part of peripheral wall 22.

Wiring board 30 covers the open end of housing 50 and disposed at a vent mechanism side of each battery unit 40. Furthermore, as shown in Figs. 5A to 5C, wiring board 30 formed of ,for example, a glass-epoxy substrate includes connection terminals 32, connection plates 34, through holes 36, and power supply wiring (power line: not shown) connecting at least neighboring connection terminal 32 and connection plate 34 to each other. That is to say, the power supply wiring connects battery units 40. Each of connection terminal 32 is connected to a first electrode (for example, a positive electrode) at the vent mechanism side of each battery unit 40. Each of connection plate 34 is connected to a second electrode (for example, a negative electrode). Connection terminals 32 and connection plates 34 are formed of, for example, a nickel plate, a lead wire, or the like, and connected to the power supply wiring formed of, for example, copper foil via, for example, solder.

Each through hole 36 formed in wiring board 30 is provided in a position facing each battery unit 40 and in a different region from that of the connection terminals 32. As shown in Fig. 2C, each connection terminal 32 is provided such that it does not protrude from wiring board 30 in the thickness direction of wiring board 30, and electrically connected to a first electrode of each battery unit 40 by, for example, spot welding.

Thus, since battery units 40 can be connected to each other via wiring board 30, space necessary for routing power supply wiring, control wiring, or the like can be considerably reduced. Therefore, it is not necessary to provide a clearance space or a through hole in partition wall 52 of housing 50 forming storage part 54 for storing each battery unit 40. Consequently, each battery unit 40 can be stored in storage part 54 formed by partition walls 52 and wiring board 30 so as to be sealed. As a result, gas ejected from a battery unit in an abnormal state cannot enter the storage part of the neighboring battery unit. Therefore, even if the gas ignites and catches fire, entry of flame is prevented, and the influence thereof can be inhibited reliably.

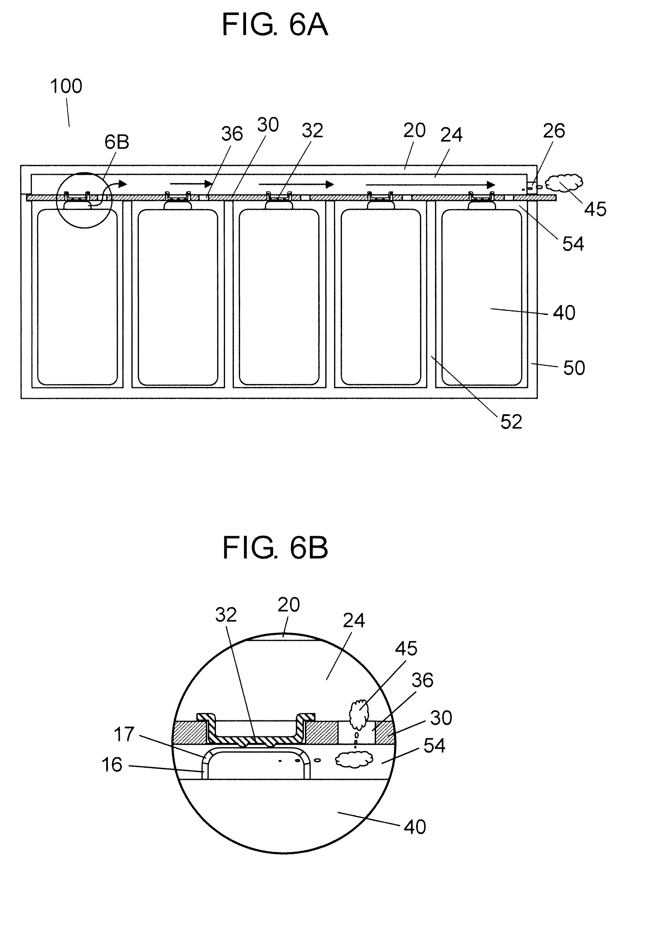

Hereinafter, in battery module 100, an operation and an effect of battery module 100 when abnormal heat generation and the like occurs in one of battery units 40 are described with reference to Figs. 6A and 6B. Fig. 6A is a sectional view illustrating a state in which gas, which is ejected when abnormal heat generation occurs in one of battery units 40, is exhausted in battery module 100, and Fig. 6B is an enlarged sectional view of part 6B of Fig. 6A.

As shown in Fig. 6B, when battery unit 40 abnormally generates heat and a pressure of gas generated in an outer case rises, a vent mechanism, for example, a safety valve works and the gas is ejected. The ejected gas is sprayed from vent hole 17 of positive electrode cap 16 into storage part 54 formed by wiring board 30 and partition walls 52 of housing 50.

As shown in Fig. 6A, gas 45 is exhausted from through hole 36 of wiring board 30 into exhaust chamber 24 of lid 20 without filling storage part 54. Gas 45 is finally exhausted from open part 26 provided in lid 20 to the outside of battery module 100.

when gas 45 is rapidly ejected from battery unit 40, the risk that gas 45 ignites and catches fire is generally increased. However, in battery module 100 having the above-mentioned configuration, an amount of oxygen in storage part 54 is limited, and oxygen is not supplied from the outside because storage part 54 is a sealed space. Therefore, the possibility that the gas ignites is extremely low, and the gas is exhausted from through hole 36 of wiring board 30 in a state of gas 45. Thus, since explosive expansion of gas 45 due to ignition does not occur, battery module 100 does not rupture at all. Furthermore, partition walls 52 of housing 50 can prevent heat of battery unit 40 that abnormally generates heat from being transferred to the neighboring battery unit. As a result, an influence of heat transfer from the storage part storing the battery unit that abnormally generates heat to a battery unit stored in another storage part can be considerably suppressed.

According to this exemplary embodiment, battery unit 40 can be stored in storage part 54 of housing 50 with at least wiring board 30 and partition walls 52 in a sealed state. Therefore, since gas 45 ejected when battery unit 40 is in an abnormal state is not supplied with oxygen from the outside, it can be exhausted to the outside of battery module 100 in a state of gas from through hole 36 of wiring board 30. Therefore, it is possible to achieve a battery module having an excellent safety in which fire or smoke due to ignition of gas 45 do not occur.

Furthermore, since each battery unit 40 is stored in storage part 54 partitioned by partition walls 52 in housing 50, an amount of heat transferred to the surrounding battery units is suppressed, thus enabling the influence thereof to be minimized. In addition, space necessary for routing power supply wiring, control wiring, or the like, can be considerably reduced by wiring board 30. As a result, a battery module having a smaller size, higher safety and an excellent reliability can be achieved.

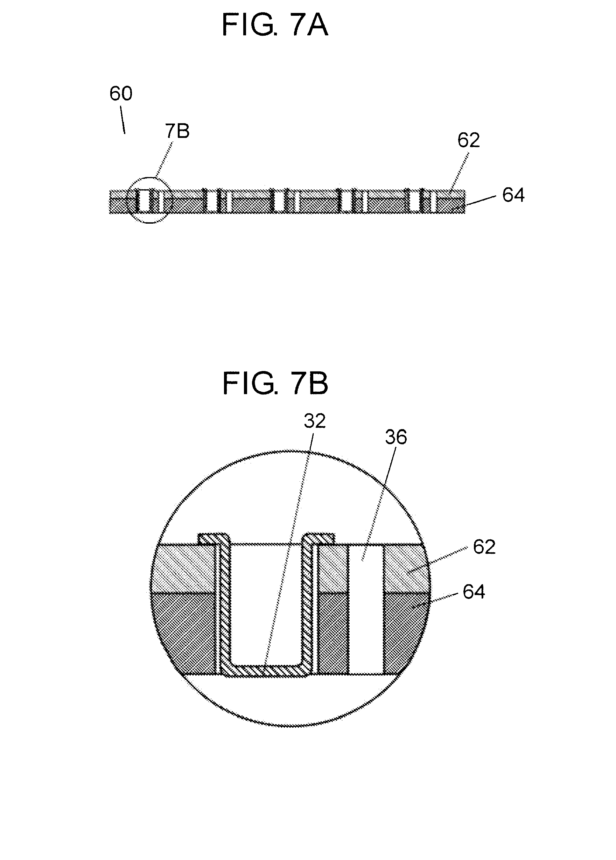

This exemplary embodiment describes a glass-epoxy substrate as an example of wiring board 30, but not limited to this. For example, as shown in a sectional view of Fig. 7A, wiring board 60 composed of flexible substrate 62 and reinforcing member 64 supporting flexible substrate 62 may be used. Flexible substrate 62 is configured by sandwiching power supply wiring (not shown) and/or control wiring (not shown) made of, for example, copper foil by polyimide resin, polyethylene terephthalate resin (PET), or the like. Reinforcing member 64 is attached to flexible substrate 62.

As shown in Fig. 7B, wiring board 60 has connection terminals 32 each connected to a first electrode of battery unit 40. It is preferable that connection terminal 32 is formed in state in which, for example, a nickel plate is exposed taking spot welding or the like into consideration.

As reinforcing member 64, polyphenylene sulfide (PPS) resin, polycarbonate (PC) resin, polyether ether ketone (PEEK) resin, phenol resin, UNILATE, glass epoxy resin, ceramic, and the like can be used. Note here that the above-mentioned resin may contain filler such as carbon fiber and glass fiber. Furthermore, as wiring board 60, a bus bar and the like may be formed in the same material as that of reinforcing member 64 by insert molding. Thus, it is possible to enhance the mechanical strength of wiring board 60, and to improve deformation resistance or heat resistance of wiring board 60 with respect to the pressure of the ejected gas. Therefore, it is possible to enhance the reliability and safety. In this way, use of flexible substrate 62 enhances the workability and facilitates handling, and reinforcement of flexible substrate 62 with reinforcing member 64 improves the sealing degree of storage part 54.

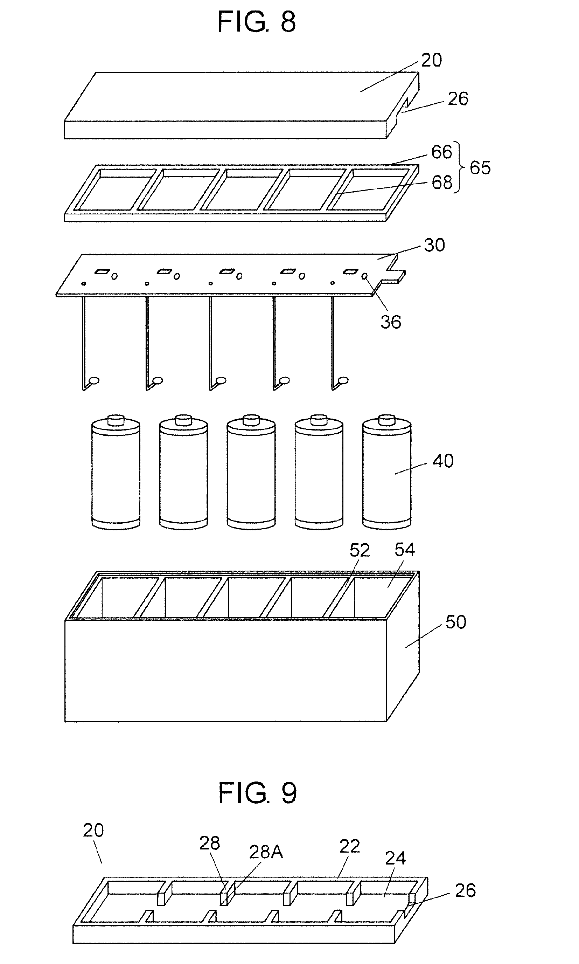

Furthermore, this exemplary embodiment describes an example of a structure in which housing 50 and lid 20 are fitted with each other, and thereby peripheral wall 22 of lid 20 and partition walls 52 of housing 50 hold wiring board 30. However, the present invention is not limited to this. For example, as shown in a battery module shown in an exploded perspective view of Fig. 8, supporting member 65 supporting wiring board 30 may be interposed between lid 20 and wiring board 30. Supporting member 65 includes at least outer peripheral frame 66 supporting the outer peripheral part of wiring board 30 and supporting parts 68 provided in positions facing partition walls 52 of housing 50. In a case that supporting part 68 of supporting member 65 makes space in exhaust chamber 24 of lid 20 small, a part of supporting part 68 may be provided with a concave portion or a hole so as to communicate with open part 26 of lid 20. Thus, with partition walls 52 of housing 50 and supporting parts 68 of supporting member 65, wiring board 30 can be reliably fixed. Therefore, deformation of wiring board 30 on one of partition walls 52 between neighboring storage parts 54 due to the pressure of the ejected gas can be suppressed. As a result, the sealing degree of storage part 54 is improved, thus suppressing the entry of heat or gas into the neighboring battery units 40 more efficiently. Thus, it is possible to achieve a battery module with further improved reliability and safety.

Alternatively, instead of providing supporting member 65, as shown in Fig. 9, rib parts 28 each having opening hole 28A may be provided in positions of exhaust chamber 24 of lid 20 facing partition walls 52 of housing 50. Thus, partition walls 52 of housing 50 and rib parts 28 of lid 20 can fix wiring board 30, and the battery module can be made smaller or thinner. Furthermore, rib parts 28 of lid 20 and partition walls 52 of housing 50 sandwich wiring board 30 reliably, and thus the sealing degree of each storage part 54 storing each battery unit 40 can be further improved.

Furthermore, this exemplary embodiment describes an example in which power supply wiring is formed on wiring board 30. However, the present invention is not limited to this. For example, voltage detection wiring for detecting a voltage of each battery unit 40 and temperature detection wiring for detecting a temperature of each battery unit 40 may be provided on wiring board 30. In such a case, a temperature detector such as a thermistor is connected to the temperature detection wiring, and each of such temperature detectors can be brought into contact with each battery unit 40 to detect a temperature. Thus, voltages and temperatures of a plurality of battery units 40 can be detected and controlled individually. As a result, since the voltages and temperatures can be controlled by taking property variation or change over time of battery units 40 into consideration, reliability and safety can be further enhanced. Note here that since a large amount of electric current flows in the power supply wiring, it is necessary to reduce electric loss due to wiring resistance. However, voltage detection wiring and the temperature detection wiring can carry out detection with a small amount of electric current. Therefore, the pattern width of the voltage detection wiring or the temperature detection wiring on wiring board 30 can be considerably narrow as compared with the pattern width of the power supply wiring. As a result, the power supply wiring and a plurality of pairs of the voltage detection wiring and the temperature detection wiring can be disposed efficiently to form wiring board 30. Therefore, space necessary for wiring can be reduced considerably.

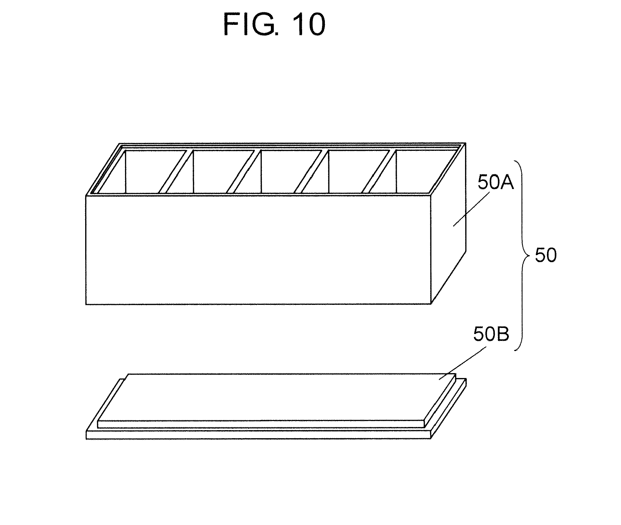

Furthermore, this exemplary embodiment describes an example in which the open end is provided on one side of housing 50. However, the present invention is not limited to this. For example, as shown in Fig. 10, housing 50 may have a configuration including frame body 50A having open ends on the facing surfaces and a plurality of storage parts, and closing member 50B for closing one of the open ends. This makes it possible to achieve a battery module having improved assembly property and workability such as connection between battery units 40 and wiring board 30, and thus having excellent productivity.

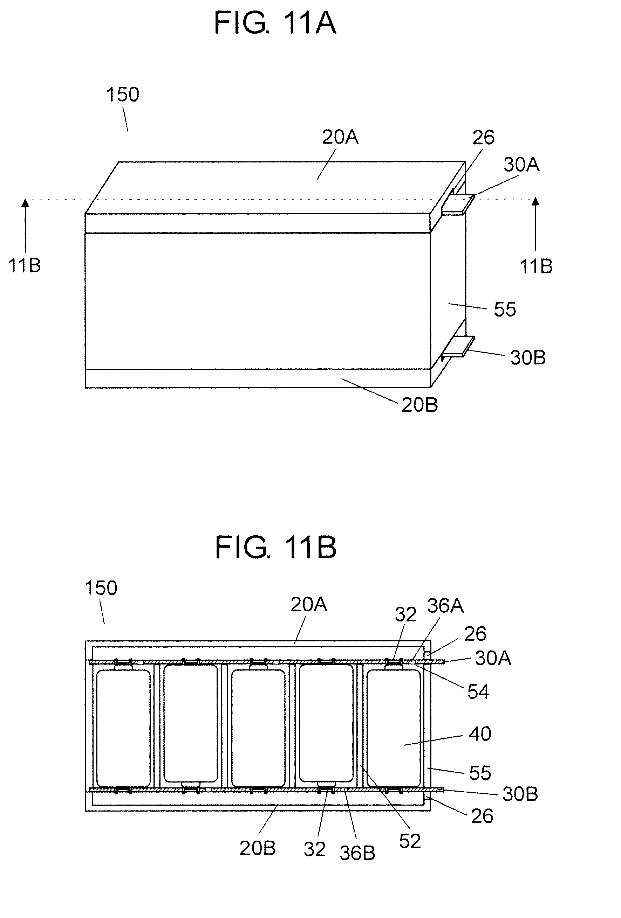

Furthermore, this exemplary embodiment describes an example in which a plurality of battery units 40 are disposed with vent mechanisms aligned in the same direction. However, the present invention is not limited to this. Fig. 11A is an outline perspective view illustrating another example of a battery module in this exemplary embodiment, and Fig. 11B is a sectional view taken along line 11B-11B of Fig. 11A. In this way, battery units 40 may be stored with the vent mechanisms disposed in the different directions.

As shown in Fig. 11B, in battery module 150, a plurality of battery units 40, in which the vent mechanisms are disposed alternately, are connected to wiring boards 30A and 30B each other. Then, lids 20A and 20B are fitted with housing 55, and battery units 40 are stored in storage parts 54 of housing 55. Through holes 36A and 36B are respectively provided in wiring boards 30A and 30B in a region which is different from that of connection terminals connected to the vent mechanism side of each battery unit 40 and which faces storage part 54. Also in this case, the same effect as mentioned above can be obtained. Furthermore, connection plate 34 can be eliminated, and connection to a plurality of battery units 40 is easy. Thus, assembly property and workability are considerably improved. This is because unlike battery module 100, it is not necessary that a plurality of battery units 40 and wiring board 30 are connected to each other and then stored in housing 50. That is to say, for example, connection terminal 32 and battery unit 40 can be simultaneously connected, in a state in which battery units 40 are stored in housing 55 and battery units 40 are sandwiched between wiring boards 30A and 30B.

### (SECOND EXEMPLARY EMBODIMENT)

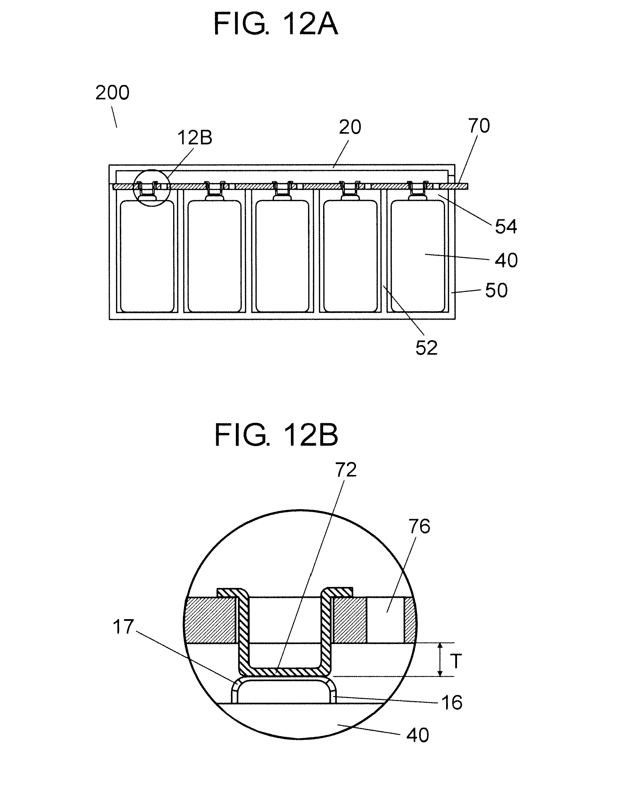

Fig. 12A is a sectional view of a battery module in accordance with a second exemplary embodiment of the present invention. Fig. 12B is an enlarged sectional view of part 12B in Fig. 12A. Note here that Fig. 12A is a sectional view of a battery module, which corresponds to the sectional view taken along line 2B-2B of Fig. 2A.

As shown in Fig. 12A, connection terminals 72 having a predetermined shape protrude from wiring board 70 in battery module 200. A predetermined space is provided between wiring board 70 and a first electrode at the vent mechanism side of each battery unit 40. Battery module 200 is different from battery module 100 of the first exemplary embodiment in these points. Note here that since components other than wiring board 70 are the same as those of the first exemplary embodiment, the description thereof is omitted.

Wiring board 70 formed of, for example, a glass-epoxy substrate includes connection terminals 72, connection plates (not shown), through holes 76, and power supply wiring (power line: not shown) connecting between at least neighboring connection terminal 72 and the connection plate to each other. Connection terminal 72 is connected to a first electrode (for example, a positive electrode) at the vent mechanism side of battery unit 40. The connection plate is connected to a second electrode (for example, a negative electrode). Each through hole 76 is provided in a position facing each battery unit 40 and in a different region from that of the connection terminals 72.

Connection terminal 72 has a C-shaped cross-section having a bottom surface as shown in Fig. 12B, and a bottom surface portion protrudes toward battery unit 40 from wiring board 70 with a predetermined space (corresponding to T in the drawing) in the thickness direction of wiring board 70. Then, a first electrode of battery unit 40 and the bottom surface portion of connection terminal 72 are electrically connected to each other by, for example, spot welding. Connection terminal 72 is formed by pressing a nickel plate.

Also in this configuration, gas ejected from a battery unit in an abnormal state cannot enter a storage part of an adjacent battery unit. Therefore, if the gas ignites and catches fire, entry of flame is prevented, and the influence thereof can be inhibited reliably. In particular, as described in detail in the below-mentioned another example of the battery module, in a case that a battery unit including a plurality of battery cells is stored in storage part 54 of housing 50, the effect is large. This is because even if a cell that is not disposed in the vicinity of through hole 76 of wiring board 70 is in an abnormal state, space in which the gas ejected from a vent hole of this cell is exhausted can be secured by the predetermined space of connection terminal 72, the gas can be exhausted from through hole 76 easily. As can be understood, space T may be appropriately adjusted according to an amount of gas to be emitted from battery unit 40. A hole may be formed on, for example, the side surface of a folding portion of connection terminal 72, so that the hole has the same function as through hole 76. Thus, exhausting efficiency of gas can be improved.

According to this exemplary embodiment, the same effect as that of the first exemplary embodiment can be obtained. Furthermore, by providing a predetermined space between wiring board 70 and battery unit 40 by connection terminals 72, exhaust resistance of gas to be ejected can be reduced and the gas can be exhausted efficiently and reliably. Furthermore, with a simple structure in which connection terminal 72 is allowed to protrude from wiring board 70, the predetermined spaces between wiring board 70 and battery units 40 can be formed uniformly.

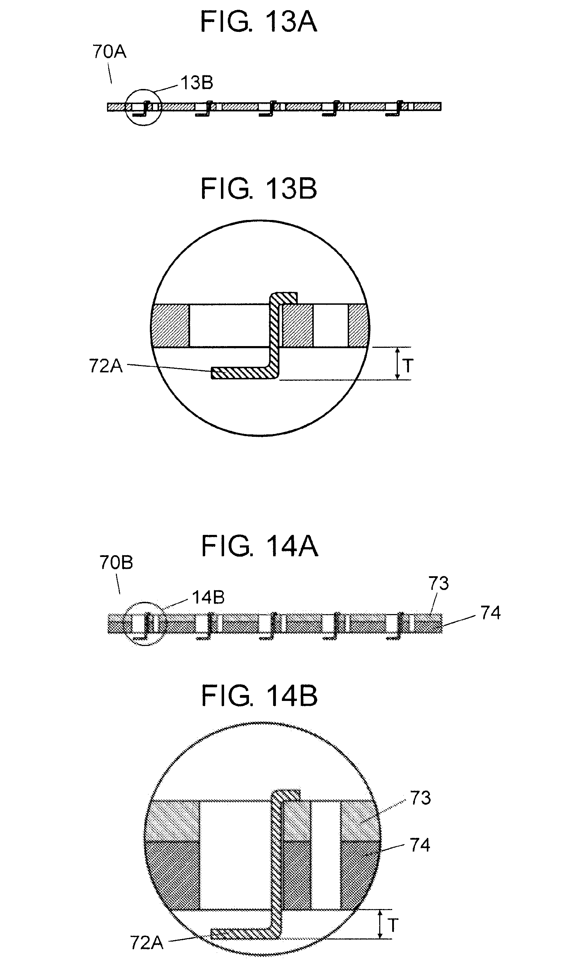

This exemplary embodiment describes an example of connection terminal 72 having a C-shaped cross-section. However, the present invention is not limited to this example. For example, as shown in Figs. 13A and 13B, a predetermined space may be provided between wiring board 70A and each battery unit 40 by providing connection terminal 72 having an L-shaped cross-section. Furthermore, the shape of the connection terminal is not limited to the above-mentioned shapes, and any shapes can be employed as long as they can secure a predetermined space and can be subjected to, for example, spot welding.

Furthermore, as shown in Figs. 14A and 14B, for example, wiring board 70B may be formed by attaching flexible substrate 73 and reinforcing member 74 to each other. In this case, the same effect can be obtained as that in the first exemplary embodiment described with reference to Fig. 7.

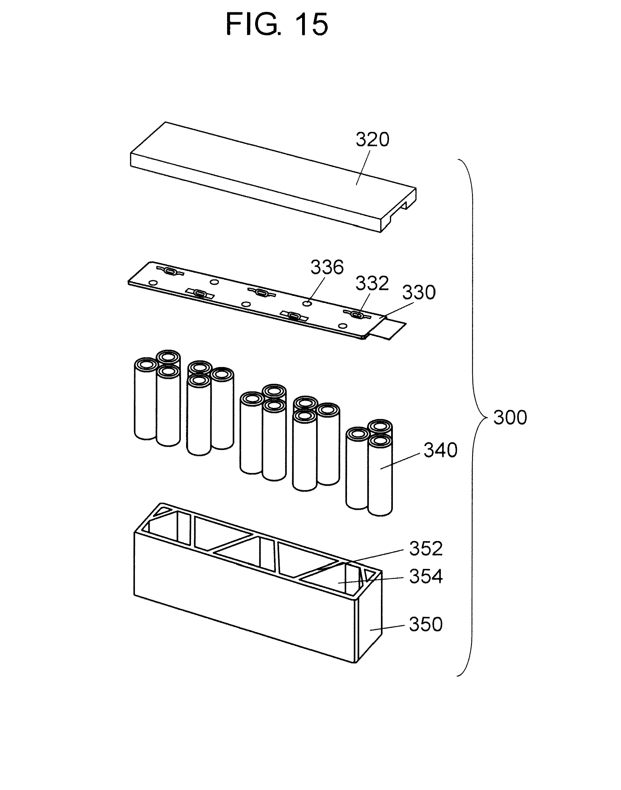

Next, another example of a battery module in this exemplary embodiment is described with reference to Fig. 15. Fig. 15 is an exploded perspective view illustrating another example of a battery module in accordance with the second exemplary embodiment of the present invention.

In battery module 300, battery units 340 each including, for example, three cells connected in parallel are used. Then, each battery unit 340 is stored in storage part 354 partitioned by partition walls 352 of housing 350. Battery module 300 is different from battery module 200 in this point.

More specifically, firstly, the vent mechanism sides of three cells are aligned, and first electrodes of the three cells are connected to each other and second electrodes are connected to each other to form battery unit 340. Then, a first electrode of each battery unit 340 is connected to connection terminal 332 of wiring board 330, and a second electrode is connected to a connection plate (not shown). Then, battery units 340 are stored in storage part 354 of housing 350. Similar to the configuration described with reference to Fig. 12B, connection terminals 332 of wiring board 330 protrude from wiring board 330 so that a predetermined space is formed. Connection terminal 332 is connected to a first electrode of one cell constituting battery unit 340 by, for example, spot welding. Furthermore, at least one through hole 336 is provided in wiring board 330, in position which is a different region from that of the connection terminals 332 and which is in, for example, a position facing the vent mechanism part of the other batteries of battery unit 340. Note here that, in wiring board 330, it is preferable that an opening portion is provided in the periphery of the position on which connection terminal 332 is formed.

Thus, in battery unit 340 including a plurality of battery cells, even if at least one cell is in an abnormal state and ejects gas, the gas can be reliably exhausted from through hole 336 efficiently. Furthermore, for example, by providing an open part around the peripheral portion (periphery) by using connection terminal 332 having a C-shaped cross-section, gas can be exhausted more efficiently.

This exemplary embodiment describes an example in which a battery unit is configured by using three cells. However, the present invention is not limited to this example. For example, according to the required electric capacity, three or more cells may be connected in parallel to form a battery unit. At this time, it is preferable that a plurality of through holes 336 are provided in wiring board 330 as the number of batteries to constitute the battery unit is increased.

### (THIRD EXEMPLARY EMBODIMENT)

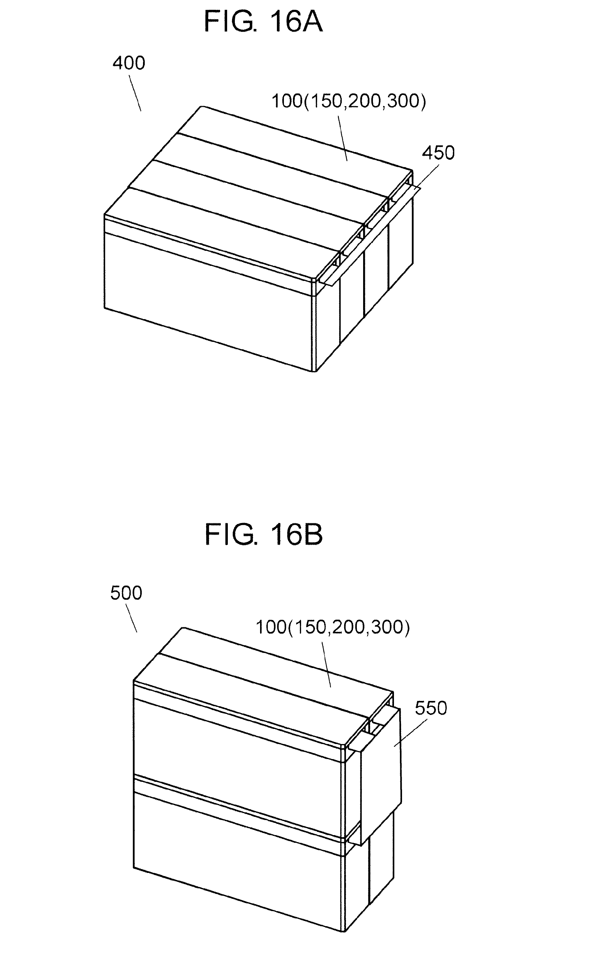

Figs. 16A and 16B are assembly perspective views showing a battery module assembly in accordance with a third exemplary embodiment of the present invention. Battery module assembly 400 shown in Fig. 16A has a configuration in which four battery modules 100 described in the first exemplary embodiment are arranged and connected by connection member 450. Furthermore, battery module assembly 500 shown in Fig. 16B has a configuration in which two units including two battery modules 100, which is described in the first exemplary embodiment, are piled in two stages longitudinally, and connected by connection member 550. Battery modules 100 are connected in parallel or in series, or combination thereof via connection member 450 or 550.

According to this exemplary embodiment, depending upon the applications of use, highly versatile battery module assemblies 400 and 500 having arrangement space and necessary voltage and capacity can be configured by arbitrarily combining battery modules 100. Note here that instead of battery module 100, any of battery modules 150, 200, and 300, which are described in the first and second exemplary embodiments, may be used.

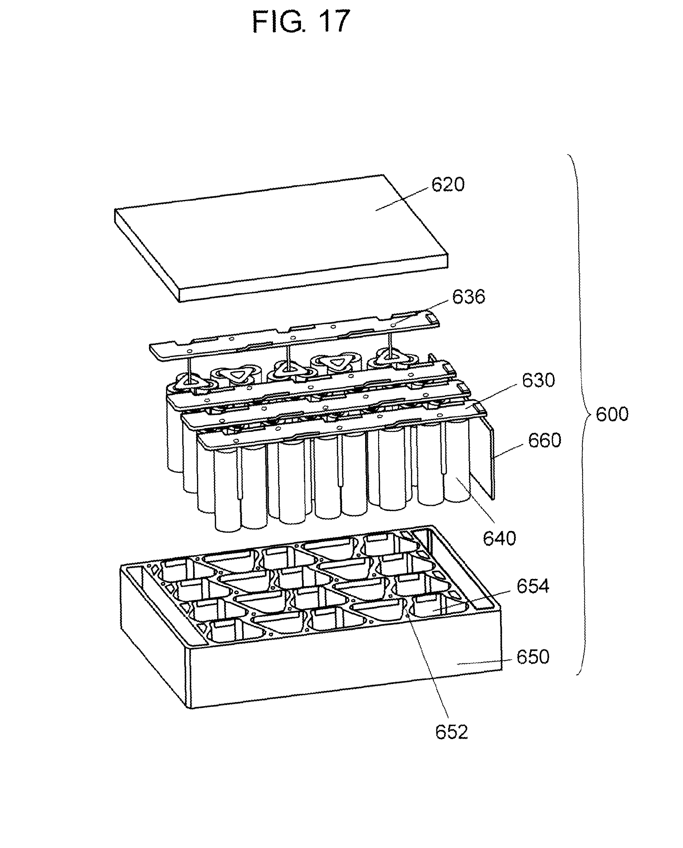

Next, another example of a battery module assembly is described with reference to Fig. 17. Fig. 17 is an exploded perspective view of another example of a battery module assembly in accordance with this exemplary embodiment. The configuration of battery module assembly 600 is different from that of battery module 300 shown in Fig. 15 in that a plurality of battery units 640 are integrally stored in two-dimensional arrangement.

That is to say, battery module assembly 600 includes housing 650, a plurality of battery units 640, wiring boards 630 and lid 620. Housing 650 includes a plurality of storage parts 654 partitioned by partition walls 652 two- dimensionally in the first direction and the second direction. Battery units 640 are stored in storage parts 654, respectively. Wiring board 630 connects a group of battery units 640 disposed along the first direction among battery units 640 in single-dimensional arrangement. Lid 620 is fitted with housing 650 in which battery units 640 are stored in a sealed state.

Wiring boards 630 are connected in parallel or in series or combination thereof by ECU (Electric Control Unit) 660. That is to say, ECU 660 is a connection member for connecting wiring boards 630. As described above, battery module assembly 600 can be regarded as a battery module in which battery units 640 are arranged two-dimensionally and they are connected by using a plurality of wiring boards 630 and ECU 660.

Wiring board 630 can detect and control temperatures and/or voltages of the battery cells, and can transmit/receive such information to/from the external apparatus. Lid 620 is provided with an exhaust chamber (not shown) and an open part (not shown) for exhausting the ejected gas such that they correspond to, for example, each wiring board 630. This configuration is similar to the configuration of 22 shown in Fig. 4. Furthermore, ribs may be provided on the rear side of lid 620 such that battery modules connected by each wiring board 630 are partitioned. Furthermore, in wiring board 630, one or more through holes 636 are provided corresponding to the vent mechanism parts of battery units 640.

In this configuration, by using an integrated housing 650, further smaller battery module assembly 600 can be achieved.

Note here that in the exemplary embodiments, a control circuit for detecting and controlling charge and discharge of the battery module, a temperature, or a voltage are not particularly described. However, it is needless to say that a control circuit may be provided in the outside or inside of the battery module.

Furthermore, each exemplary embodiment describes an example of a cylindrical cell as a battery unit. However, the present invention is not limited to this. For example, a rectangular cell may be employed. Furthermore, a cell having a positive electrode terminal, a negative electrode terminal and a vent mechanism at the same side may be employed. Thus, assembly property or workability of each battery unit and a wiring board are considerably improved. Furthermore, a configuration specific to each exemplary embodiment may be combined as possible.

### INDUSTRIAL APPLICABILITY

The present invention is useful as a battery module and a battery module assembly, which require high reliability and high safety in, for example, automobiles, bicycles, machine tools, and the like.

### REFERENCE MARKS IN THE DRAWINGS

- 1: positive electrode
- 1A: positive electrode current collector
- 1B: positive electrode layer
- 2: negative electrode
- 3: separator
- 4: electrode group
- 5: battery case
- 6: sealing plate
- 7: gasket
- 8: positive electrode lead
- 9: negative electrode lead
- 10A, 10B: insulating plate
- 11: negative electrode current collector
- 15: negative electrode layer
- 16: positive electrode cap
- 17: vent hole
- 18: current blocking member
- 19: vent mechanism
- 20, 20A, 20B, 620: lid
- 22: peripheral wall
- 24: exhaust chamber
- 26: open part
- 28: rib part
- 28A: opening hole
- 30, 30A, 30B, 60, 70, 70A, 70B,:
- 330, 630, 60, 70, 70A, 70B, 330, 630: wiring
- board 32. 72, 72A, 332: connection terminal
- 34: connection plate
- 36, 36A, 36B, 76, 336, 636: through hole
- 40, 340, 640: battery unit
- 45: gas
- 50, 55, 350, 650: housing
- 50A: frame body
- 50B: closing member
- 52, 352, 652: partition wall
- 54, 354, 654: storage part
- 62, 73: flexible substrate
- 64, 74: reinforcing member
- 65: supporting member
- 66: outer peripheral frame
- 68: supporting part
- 100, 150, 200, 300: battery module
- 400, 500, 600: battery module assembly
- 450, 550: connection member
- 660: ECU (connection member)

## Claims

1. A battery module comprising:
a plurality of battery units each including one or more cells each having a vent mechanism;
a housing having an open end on at least one surface and having a plurality of storage parts partitioned by one or more partition walls, each of the storage parts storing each of the battery units;
a wiring board covering the open end of the housing, being disposed at the vent mechanism side of the cell, and having connection terminals to be connected to the battery units; and
a lid covering the open end of the housing and the wiring board, and having an open part,
wherein through holes are provided in the wiring board in positions facing the battery units and in a different region from that of the connection terminals.

2. The battery module according to claim 1,
wherein the battery units and the wiring board are provided with a predetermined space therebetween.

3. The battery module according to claim 2,
wherein the predetermined space is formed by allowing the connection terminals to protrude from the wiring board toward the battery units.

4. The battery module according to claim 3,
wherein each of the connection terminal is provided with a hole.

5. The battery module according to claim 1,
wherein a rib part is provided on the lid in a position facing each of the partition wall of the housing.

6. The battery module according to claim 1,
wherein the wiring board includes a flexible substrate and a reinforcing member supporting the flexible substrate.

7. The battery module according to claim 1,
further comprising a supporting member provided between the lid and the wiring board, and the supporting member supporting the wiring board.

8. The battery module according to claim 1,
further comprising temperature detectors each capable of detecting a temperature of corresponding one of the battery units,
wherein the wiring board comprises:
power supply wiring connecting battery units, and
a plurality of pairs of temperature detection wiring and voltage detection wiring, and
wherein each of the temperature detection wirings is connected to each of the temperature detectors, and each of the voltage detection wirings is used for detecting a voltage of each of the battery units.

9. The battery module according to claim 1,
wherein the housing comprises a frame body having open ends on two surfaces facing each other; and
a closing member closing one of the open ends of the frame body.

10. The battery module according to claim 1,
wherein the storage parts are disposed in the housing two-dimensionally in a first direction and a second direction,
the wiring board is one of a plurality of wiring boards,
each of the plurality of wiring boards one-dimensionally connects a pair of battery units disposed along the first direction among the battery units stored in the storage parts, and,
a connection member connecting the plurality of wiring boards is further provided.

11. A battery module assembly comprising:
a plurality of the battery modules according to claims 1; and
a connection member connecting the battery modules at least one of in series and in parallel.
